# EUROPEAN PATENT APPLICATION

(11) **EP 4 819 113 A1**
(43) Date of publication of application: **07.10.2026**
(21) Application number: 24895353.1
(22) Date of filing: 21.03.2024
(51) Int. Cl.: G09F 9/33, H01L 25/075

(54) **TRANSPARENT DISPLAY SCREEN**

(30) Priority: 01.12.2023 CN 202323308161 U
(71) Applicant: Lin, Jianhan, Shenzhen, Guangdong 518000 (CN)
(72) Inventor: Lin, Jianhan, Shenzhen, Guangdong 518000 (CN)
(74) Representative: Herrero & Asociados, S.L.
(86) International application number: PCT/CN2024/082898
(87) International publication number: WO 2025/112240

(57) **Abstract**

To address the problems existing in the transparent LED display screen of the prior art, the present application provides a transparent display screen, including a light-transmitting motherboard and one or more transparent light-emitting modules mounted on the light-transmitting motherboard. The light-transmitting motherboard is provided with a transmission circuit configured to supply power and signals to the transparent light-emitting module. Each transparent light-emitting module is provided with a driver circuit and a plurality of light-emitting pixels arranged in an array. Each light-emitting pixel is connected to the driver circuit, and the driver circuit is connected to the transmission circuit of the light-transmitting motherboard. light-transmitting motherboardIn this application, the transparent light-emitting module and the transparent motherboard are provided as separate components. The transparent light-emitting module is generally smaller in size and can be manufactured more conveniently, efficiently, and with more stable quality within the processing range of precision equipment. The transparent motherboard, on the other hand, can be made in larger sizes. Since its internal circuit structure is relatively simple and highly integrated, stable quality is easier to ensure, and after-sales service is more convenient.

## Description

This application claims priority to Chinese Patent Application No. 202323308161.0, filed on December 1, 2023, titled "Transparent Display Screen", the contents of which are incorporated herein by reference in their entirety.

### Technical Field

The present application relates to the field of LED transparent display screens.

### Background

Transparent LED display screens have gradually gained wide application in the market and have evolved into various product forms. A typical transparent LED display screen includes a transparent substrate and a plurality of LED lamp beads arranged in an array on the transparent substrate. The transparent substrate generally includes either a transparent glass substrate or a non-transparent substrate provided with light-transmitting holes or light-transmitting grooves to achieve transparency through these holes or grooves.

Currently, transparent substrates with light-transmitting holes available on the market are generally based on printed circuit boards (PCBs). LED lamp beads with built-in driver chips are mounted in the non-transparent areas outside the light-transmitting holes. These PCB-based substrates typically need to be manufactured with lengths of 1 to 1.5 meters. Such lengths make the PCBs, especially those with arrays of light-transmitting holes, quite fragile. Moreover, the non-transparent areas are narrow and thin, making the entire board prone to damage if broken, which is unfavorable for production quality control and practical installation.

Regarding the LED lamp beads with built-in driver chips, the inventors have recoginized that these chips often use an addressing method to determine the position of the LED lamp beads on the display screen, with each lamp having a unique address. This results in the need to manage a large number of different materials during production and causes difficulties in after-sales service.

### Summary of the Invention

To address the above problems, the present application provides a transparent display screen, including: a light-transmitting motherboard and one or more transparent light-emitting modules mounted on the light-transmitting motherboard; wherein:
the light-transmitting motherboard is provided with a transmission circuit configured to supply power and signals to the transparent light-emitting module; the light-transmitting motherboard and the transparent light-emitting module together present a transparent display effect; and
each transparent light-emitting module is provided with a driver circuit and a plurality of light-emitting pixels arranged in an array, each light-emitting pixel includes a driver chip and a light-emitting die; each of the light-emitting pixels is connected to the driver circuit, and the driver circuit is connected to the transmission circuit of the light-transmitting motherboard, thereby electrically connecting each transparent light-emitting module to the light-transmitting motherboard to supply power and signals to the light-emitting pixels on the transparent light-emitting module.

In this application, the transparent light-emitting module and the light-transmitting motherboard are provided as separate components. The transparent light-emitting module is generally smaller in size and can be manufactured more conveniently, efficiently, and with more stable quality within the processing range of precision equipment. The light-transmitting motherboard, on the other hand, can be made in larger sizes. Since its internal circuit structure is relatively simple and highly integrated, stable quality is easier to ensure, and after-sales service is more convenient.

Further, the transparent light-emitting module is provided with an electrical connection part; and the light-transmitting motherboard is provided with a module connection part, the module connection part on the light-transmitting motherboard is electrically connected to the electrical connection part on the module substrate, thereby electrically connecting the driver circuit on the transparent light-emitting module to the transmission circuit on the light-transmitting motherboard, and supplying power and signals from the light-transmitting motherboard to the transparent light-emitting module.

Further, the electrical connection part on the transparent light-emitting module and the module connection part on the light-transmitting motherboard are each correspondingly provided with a plurality of power connection structures and signal connection structures.

Further, the power connection structure on the transparent light-emitting module is a first power connection hole, and the signal connection structure is a first signal connection hole; the power connection structure on the light-transmitting motherboard is a second power connection hole, and the signal connection structure is a second signal connection hole; the first power connection hole is connected to the second power connection hole, and the first signal connection hole is connected to the second signal connection hole, via electrical connectors.

Further, the power connection structure and the signal connection structure on the transparent light-emitting module are arranged either concentrically or dispersedly at a corner or an edge of the transparent light-emitting module.

Further, the transparent light-emitting module and the light-transmitting motherboard are both printed circuit boards, each composed of at least two circuit layers; the light-transmitting motherboard is provided with a light-transmitting area, and the transparent light-emitting module is provided with light-transmitting holes arranged in an array; and
the circuit layers on the light-transmitting motherboard form the transmission circuit, and the transmission circuit is configured to provide power and signals to the module substrate; the circuit layers on the transparent light-emitting module form the driver circuit, and the driver circuit is configured to provide power and signals to each of the light-emitting pixels.

Further, the light-transmitting holes on the transparent light-emitting module and the light-transmitting motherboard include: central light-transmitting holes of a full-hole shape in the center area, adjacent-edge light-transmitting holes of a semi-hole shape at edge positions, and adjacent-corner light-transmitting holes of a quarter-hole shape at corner positions; the adjacent-edge light-transmitting holes of two adjacent light-emitting modules are able to combine to form a full-hole shape, and the adjacent-corner light-transmitting holes of four adjacent light-emitting modules are able to combine to form a full-hole shape.

Further, the number of the transparent light-emitting modules is N, and the light-transmitting motherboard includes a non-light-transmitting frame and N hollow light-transmitting areas formed in the non-light-transmitting frame, and each hollow light-transmitting area is correspondingly provided with one of the transparent light-emitting modules.

Further, the light-transmitting motherboard further is further provided with an external connection port area connected to the power module and the signal module; and the external connection port area is provided with a connection PIN connected to the power module and the signal module.

Further, the transparent light-emitting module is adhesively bonded to the light-transmitting motherboard.

Further, the light-transmitting motherboard is a transparent glass panel, and the transmission circuit is provided on the transparent glass panel.

Further, the transparent light-emitting module includes a transparent substrate, and the driver circuit is provided on the transparent substrate; and the light-emitting pixels are arranged in an array on the driver circuit of the transparent substrate.

The details of one or more embodiments of this application are presented in the following drawings and descriptions. Other features and advantages of the application will become apparent from the description, drawings, and claims.

### Brief Description of the Drawings

Fig. 1 is a perspective exploded view of the first transparent display screen provided in a specific embodiment of the present application.
Fig. 2 is a top-down view of the transparent light-emitting module in the first transparent display screen provided in a specific embodiment of the present application.
Fig. 3 is a perspective view of the transparent light-emitting module in the first transparent display screen provided in a specific embodiment of the present application.
Fig. 4 is a top-down view of the light-transmitting motherboard in the first transparent display screen provided in a specific embodiment of the present application.
Fig. 5 is an enlarged view of area A in Fig. 4.
Fig. 6 is a top-down view of the first transparent display screen provided in a specific embodiment of the present application.
Fig. 7 is an enlarged view of area B in Fig. 6.
Fig. 8 is a perspective exploded view of the second transparent display screen provided in a specific embodiment of the present application.
Fig. 9 is an enlarged view of area C in Fig. 8.
Fig. 10 is a perspective exploded view of the third transparent display screen provided in a specific embodiment of the present application.
Fig. 11 is an enlarged view of area D in Fig. 10.
Fig. 12 is a perspective exploded view of the fourth transparent display screen provided in a specific embodiment of the present application.
Fig. 13 is an enlarged view of area E in Fig. 12.
Fig. 14 is a perspective exploded view of the fifth transparent display screen provided in a specific embodiment of the present application.
Fig. 15 is a perspective view of the transparent light-emitting module in the fifth transparent display screen provided in a specific embodiment of the present application.
Fig. 16 is a perspective exploded view of the sixth transparent display screen provided in a specific embodiment of the present application.
Fig. 17 is an enlarged view of area F in Fig. 16.
Fig. 18 is a schematic diagram of power supply and signal control for the transparent display screen provided in a specific embodiment of the present application.

In the detailed embodiments, the reference signs in the drawings are as follows: 100. Transparent light-emitting module; 1000. Transparent display screen; 101. Peripheral non-light-transmitting area; 102. Peripheral connection area;
1. Module substrate; 2. Light-emitting pixel; 3. Light-transmitting motherboard; 4. Signal module; 5. Power module;
11. First light-transmitting hole; 12. Pixel recessed hole; 13. Electrical connection part; 11a. Central light-transmitting hole; 11b. Adjacent-edge light-transmitting hole; 11c. Adjacent-corner light-transmitting hole; 31. Second light-transmitting hole; 32. External connection port area; 32v. Positive power line; 32g. Negative power line; 32d. Signal line; 321. Connection PIN; 33. Module connection part; 331. Electrical connector; 34. Non-light-transmitting frame; 31A. Hollow light-transmitting area.

### Detailed description of disclosed embodiments

To make the technical problems, technical solutions and beneficial effects of the present application more clear, the application will be further explained in detail below with reference to the drawings and embodiments. It should be understood that the specific embodiments described here are only used to illustrate the application, rather than to limit the application.

In the description of the present application, it is to be understood that the terms "longitudinal", "radial", "length", "width", "thickness", "upper", "lower", "front", "rear", "left", "right", "vertical", "horizontal", "top", "bottom", "inner", "outer", and the like indicate an orientation or positional relationship based on that shown in the drawings. They are only for convenience of description and simplicity of description only, not intended to indicate or imply that the indicated devices or elements must have a particular orientation, be constructed and operated in a particular orientation, and are therefore not to be construed as limiting the present application. In the description of the present application, unless otherwise stated, "multiple" means two or more.

In the description of this application, it should be noted that unless otherwise specified and limited, the terms "install," "connect," and "link" should be understood broadly. For example, they may be fixed connections, detachable connections, or integral connections; they may be mechanical connections or electrical connections; they may be direct connections or indirect connections through an intermediate medium, or internal communication of two elements. For those skilled in the art, the specific meanings of the above terms in this application can be understood according to specific situations.

### Embodiment 1

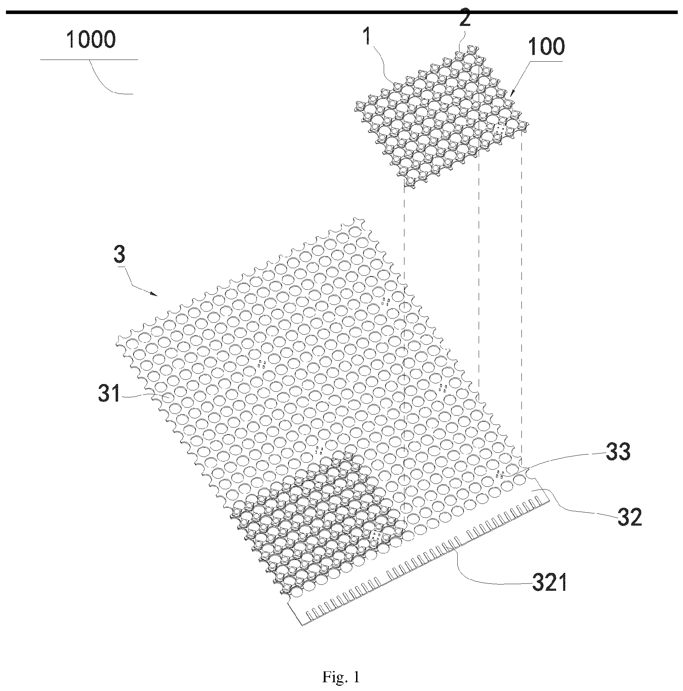

As shown in Figs. 1 to 7, the present embodiment provides a transparent display screen 1000, which includes a light-transmitting motherboard 3 and one or more transparent light-emitting modules 100 mounted on the light-transmitting motherboard 3. The light-transmitting motherboard 3 is provided with a transmission circuit (not shown in the figure) for supplying power and signals to the transparent light-emitting module 100. The light-transmitting motherboard 3 and the transparent light-emitting module 100 together provide a transparent display effect.

The transparent light-emitting module 100 is equipped with a driver circuit (not shown in the figure) and a plurality of light-emitting pixels 2 arranged in an array. Each light-emitting pixel 2 includes a driver chip and a light-emitting chip. Each light-emitting pixel 2 is connected to the driver circuit, and the driver circuit is connected to the transmission circuit of the light-transmitting motherboard 3. This arrangement electrically connects each transparent light-emitting module 100 to the light-transmitting motherboard 3, providing power and signals to the light-emitting pixels 2 on the transparent light-emitting module 100.

In this application, there is no specific limitation on the implementation of the light-transmitting motherboard 3 and the transparent light-emitting module 100, as long as they can visually achieve a transparent effect, and form transmission circuits and driver circuits on them. These circuits should be electrically connected so that they can provide power and signals to the light-emitting pixels 2 via the transmission circuits and driver circuits. The transparent light-emitting module 100 generally includes a module substrate 1, with light-emitting pixels 2 arranged on the module substrate 1. The module substrate 1 may be a multi-layer structure. Generally, the transparent display effect of the light-transmitting motherboard 3 and module substrate 1 can be achieved by using transparent materials as the substrate or carrier. For example, the light-transmitting motherboard 3 may be a transparent glass panel, with the transmission circuit provided on the transparent glass panel. The module substrate 1 of the transparent light-emitting module 100 is a transparent substrate, with a driver circuit provided on the transparent substrate. The transparent substrate may be made of transparent glass panels or transparent films, with light-emitting pixels 2 arranged on the driver circuit of the transparent substrate in an array.

The light-transmitting motherboard 3 and the transparent light-emitting module 100 can also be implemented on a non-transparent substrate or carrier by providing light-transmitting and non-light-transmitting areas. The transparent effect is achieved through the light-transmitting areas, while the driver circuit and transmission circuit are provided on the non-light-transmitting areas.

In this embodiment, non-transparent materials are used as the substrate or carrier. The projection of the light-transmitting area on the transparent light-emitting module 100 is located in the light-transmitting area on the light-transmitting motherboard 3. This means that the light-transmitting area on the transparent light-emitting module 100 is not blocked by the non-light-transmitting area on the light-transmitting motherboard 3. Preferably, both the light-transmitting motherboard 3 and the transparent light-emitting module 100 are arranged with corresponding light-transmitting holes in an array, with the areas excluding the light-transmitting holes forming a non-light-transmitting area. For example, in the case of the transparent light-emitting module 100, generally, the larger the area ratio of the light-transmitting area to the non-light-transmitting area, the higher the transparency of the transparent light-emitting module 100, resulting in better transparency and transmittance. To distinguish them, the light-transmitting holes on the transparent light-emitting module 100 are referred to as first light-transmitting holes 11, and the light-transmitting holes on the light-transmitting motherboard 3 are referred to as second light-transmitting holes 31. In this application, the transparent light-emitting module 100 is formed from a non-transparent material, and both the transparent light-emitting module 100 and the light-transmitting motherboard 3 are printed circuit boards, consisting of at least two circuit layers. The circuit layers on the light-transmitting motherboard 3 form the transmission circuit, which provides power and signals to the module substrate. The circuit layers on the transparent light-emitting module 100 form the driver circuit, which supplies power and signals to the light-emitting pixels 2. For example, the light-transmitting motherboard 3 is preferably a printed circuit board directly formed from a non-transparent material, consisting of at least two circuit layers. The circuit layers on the light-transmitting motherboard 3 form the transmission circuit, which connects to the driver circuit to supply power and signals to the light-emitting pixels 2. Similarly, the transparent light-emitting module 100 is formed from a non-transparent material, typically as a printed circuit board with at least two circuit layers, where the circuit layers form the driver circuit to provide power and signals to the light-emitting pixels 2.

The size of the light-transmitting holes can be optimized during the production process according to actual needs, balancing the transparency and transmittance and ensuring the display performance of the product. For those skilled in the art, given the solutions described in this embodiment, the above-described concept can be readily implemented without creative efforts.

The areas outside the light-transmitting holes form a non-light-transmitting area. In this embodiment, the light-transmitting and non-light-transmitting areas on the light-transmitting motherboard 3 are not necessarily designed to have a one-to-one correspondence with the light-transmitting holes and non-light-transmitting area on the transparent light-emitting module 100. It is sufficient that the projections of the light-transmitting holes on the transparent light-emitting module 100 fall within the light-transmitting area of the light-transmitting motherboard 3. Since the light-transmitting motherboard 3 does not need to have light-emitting pixels 2 arranged in an array, it only requires relatively small non-light-transmitting area to accommodate the transmission circuit. Therefore, the light-transmitting area on the light-transmitting motherboard 3 can vary in size. For example, in one embodiment, the light-transmitting area of the light-transmitting motherboard 3 includes a plurality of second light-transmitting holes 31 arranged in an array; the areas outside the second light-transmitting holes 31 form a non-light-transmitting area. The second light-transmitting holes 31 are arranged in one-to-one correspondence with the first light-transmitting holes 11 and the second light-transmitting holes 21.

In this embodiment, as a preferred solution, pixel pads (not shown in the figure) are provided on the driver circuit. The pixel pads are arranged in an array in the non-light-transmitting areas outside the first light-transmitting holes 11. A plurality of light-emitting pixels 2 are mounted on the pixel pads and electrically connected to the driver circuit through the pixel pads. Each light-emitting pixel 2 includes a driver chip and a light-emitting die. The light-emitting dies in the present application are well known in the art and commonly include red, green, and blue light-emitting dies. In the present application, each light-emitting pixel 2 includes a driver chip. Therefore, unlike conventional LED display devices where the driver chip is arranged separately, each light-emitting pixel 2 in this application integrates the driver chip. As illustrated, the light-emitting pixel 2 in this embodiment may be an LED lamp bead bead integrated with a reflector cup.

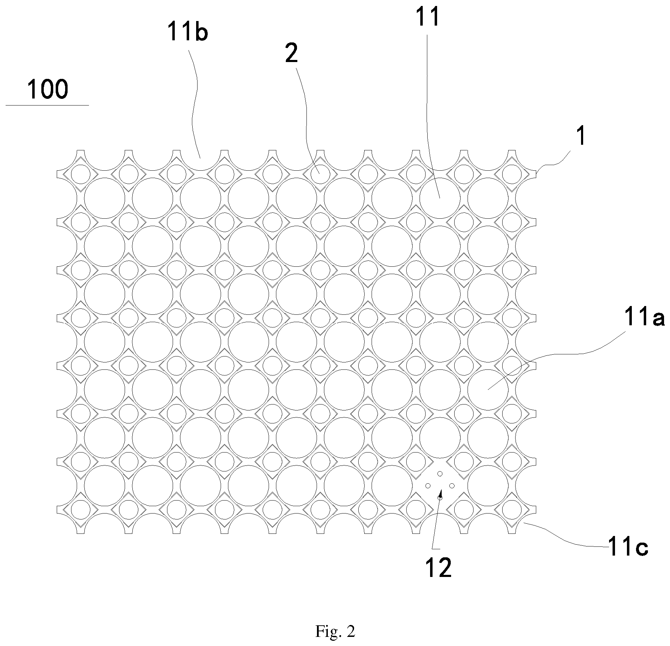

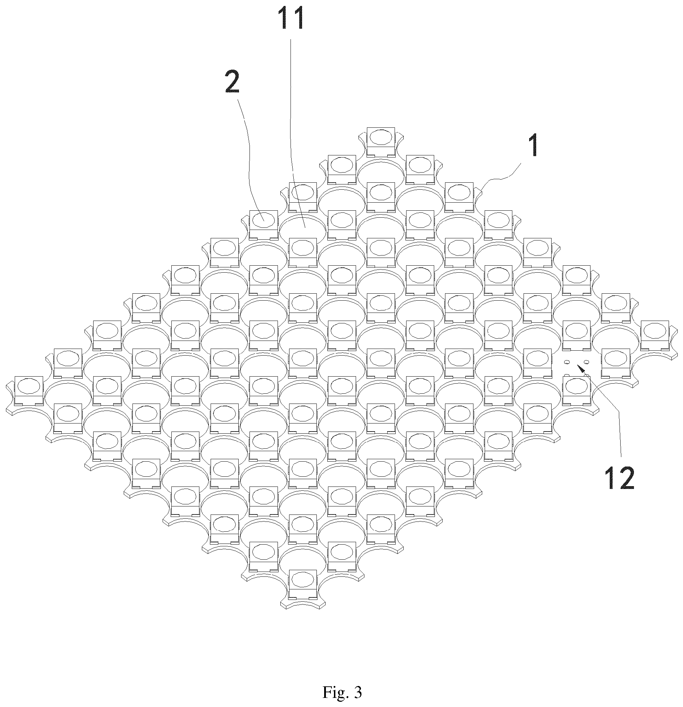

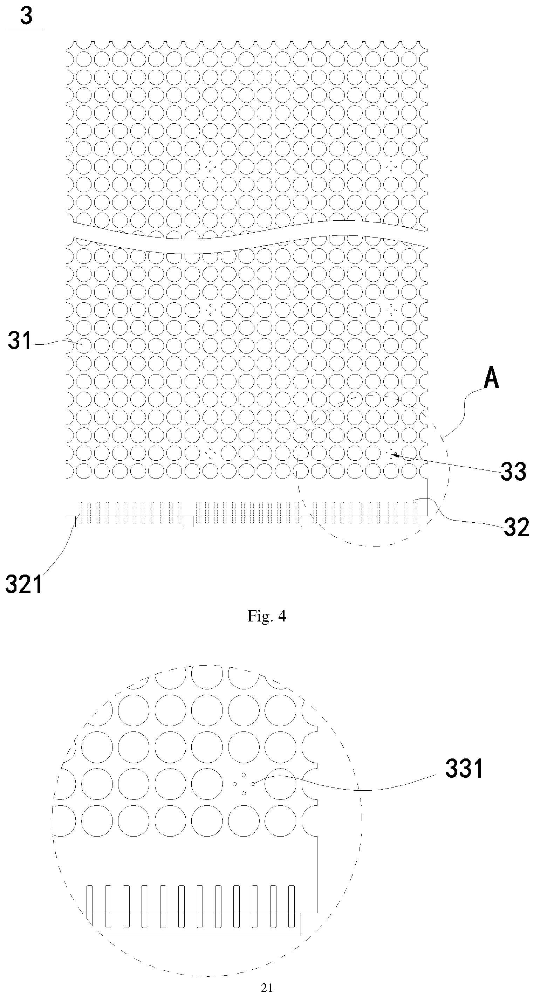

As shown in Figs. 2 and 3, an electrical connection part 13 is provided on the transparent light-emitting module 100. As shown in Fig. 4, a module connection part 33 is provided on the light-transmitting motherboard 3. The module connection part 33 on the light-transmitting motherboard 3 is electrically connected to the electrical connection part 13 on the module substrate, so as to electrically connect the driver circuit on the transparent light-emitting module 100 with the transmission circuit on the light-transmitting motherboard 3, thereby supplying power and signals from the light-transmitting motherboard 3 to the transparent light-emitting module 100.

Specifically, the electrical connection part 13 on the transparent light-emitting module 100 and the module connection part 33 on the light-transmitting motherboard 3 are each correspondingly provided with a plurality of power connection structures and signal connection structures. These power and signal connection structures are generally implemented as electrical connection holes. For example, the transparent light-emitting module 100 and the light-transmitting motherboard 3 may include metallized holes as the electrical connection holes, and the electrical connection holes are electrically connected via the above-mentioned electrical connector.

Specifically, the power connection structure on the transparent light-emitting module 100 is a first power connection hole, and the signal connection structure is a first signal connection hole. The power connection structure on the light-transmitting motherboard 3 is a second power connection hole, and the signal connection structure is a second signal connection hole. The first power connection hole is connected to the second power connection hole, and the first signal connection hole is connected to the second signal connection hole, both via electrical connectors.

In this embodiment, the electrical connection part 13 includes a plurality of power connection structures and signal connection structures in the non-light-transmitting area. The power connection structure is a first power connection hole, and the signal connection structure is a first signal connection hole. The power connection structures and signal connection structures of the electrical connection part 13 may be arranged either centrally or in a distributed manner at any position within the non-light-transmitting area of the transparent light-emitting module 100. Preferably, the power connection structures and signal connection structures of the electrical connection part 13 are arranged either centrally or in a distributed manner at the corners or edges of the module substrate 1. In this embodiment, the power connection structures and signal connection structures of the electrical connection part 13 are arranged centrally. In this embodiment, as shown in Figs. 2 and 3, the area of one or more of the first light-transmitting holes 11 in the transparent light-emitting module 100 is configured as a non-light-transmitting structure to serve as the electrical connection part 13. Similarly, as shown in Fig. 4, the area of one or more of the second light-transmitting holes 31 in the light-transmitting motherboard 3 is configured as a non-light-transmitting structure to serve as the module connection part 33. The electrical connection part 13 of the transparent substrate 1 is correspondingly connected to the module connection part 33 of the light-transmitting motherboard 3.

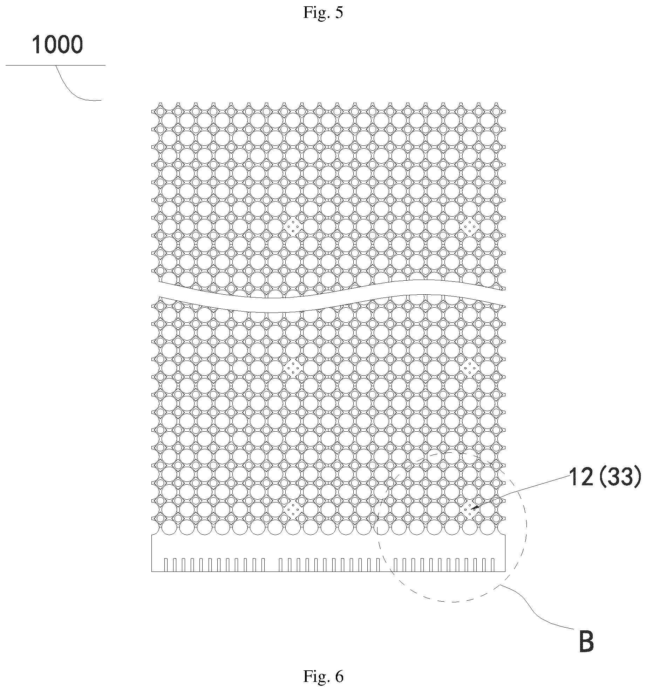

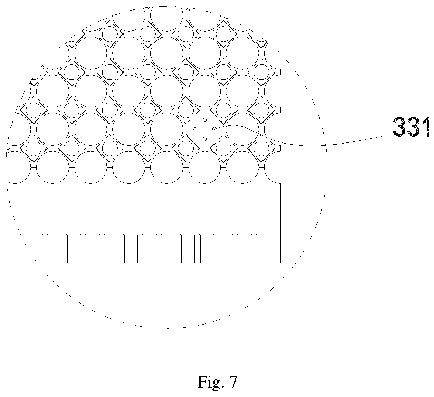

In this embodiment, the power connection structure on the transparent light-emitting module 100 is the first power connection hole, and the signal connection structure is the first signal connection hole. The power connection structure on the light-transmitting motherboard 3 is the second power connection hole, and the signal connection structure is the second signal connection hole. As shown in the enlarged schematic diagrams in Figs. 5, 7, and others, the first power connection hole and the second power connection hole, as well as the first signal connection hole and the second signal connection hole, are connected through the electrical connector 331. In this embodiment, the electrical connector 331 is a metal pin-shaped or metal column-shaped connector. These are soldered using metal pin-shaped or column-shaped connectors. Of course, the power connection structure and signal connection structure on the module substrate 1, as well as the power connection structure and signal connection structure on the light-transmitting motherboard 3, may also employ other electrical connection methods, as long as they ultimately enable electrical connection between the module substrate 1 and the light-transmitting motherboard 3.

Among the light-transmitting holes of the light-transmitting motherboard 3 and the transparent light-emitting module 100, taking the first light-transmitting hole 11 on the transparent light-emitting module 100 as an example, it includes: a central light-transmitting hole 11a of a full-hole shape arranged in the center area, an adjacent-edge light-transmitting hole 11b of a semi-hole shape arranged at edge positions, and an adjacent-corner light-transmitting hole 11c of a quarter-hole shape arranged at corner positions. The adjacent-edge light-transmitting holes 11b of two adjacent light-emitting modules are able to combine to form a full-hole shape, and the adjacent-corner light-transmitting holes 11c of four adjacent light-emitting modules are able to combine to form a full-hole shape.

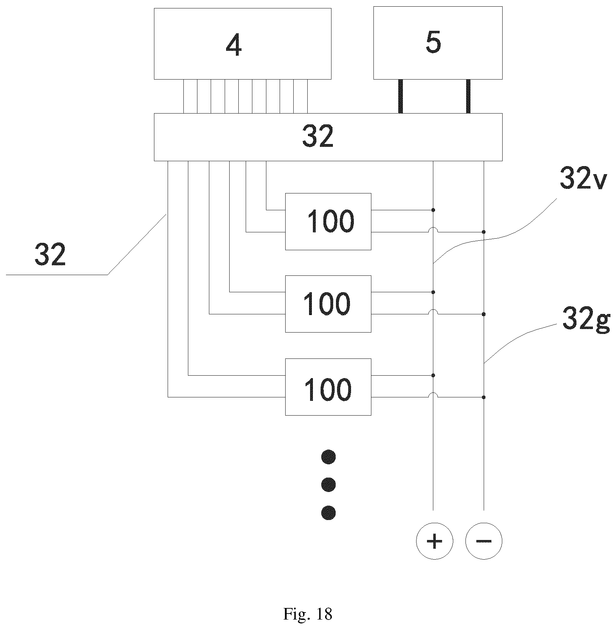

The light-transmitting motherboard 3 also includes an external connection port area 32 connected to the power module 5 and the signal module 4. The external connection port area 32 is equipped with a connection PIN 321, which is connected to the power module 5 and the signal module 4. As shown in Fig. 18, the connection PIN 321 in the external connection port area 32 is internally connected to the transmission circuit on the light-transmitting motherboard 3. Through this connection PIN 321, the external power module 5 and signal module 4 are connected. The transmission circuit includes power transmission lines and signal transmission lines. The power transmission lines include a positive power line 32v and a negative power line 32g. Both the positive power line 32v and the negative power line 32g are connected to each transparent light-emitting module 100 to provide power to each transparent light-emitting module 100. The signal transmission lines include several signal lines 32d connected to each transparent light-emitting module 100, providing signals to each transparent light-emitting module 100 through the signal lines 32d.

As a further preferred solution, the transparent light-emitting module 100 is adhesively connected to the light-transmitting motherboard 3. In this way, while achieving electrical connection between the light-transmitting motherboard 3 and the transparent light-emitting module 100, the mechanical strength of both the light-transmitting motherboard 3 and the transparent light-emitting module 100 can also be enhanced.

Since each light-emitting pixel 2 is provided with a driver chip that directly drives the light-emitting die, the internal circuit of the transparent light-emitting module 100 becomes very simple. In general, apart from the power supply lines, one signal line or at most two signal lines can be used to connect all the light-emitting pixels 2 in the transparent light-emitting module 100 in series. When N transparent light-emitting modules 100 are mounted on the light-transmitting motherboard 3, the number of signal lines required on the light-transmitting motherboard 3 can be as few as N or at most 2N. Therefore, neither the transparent light-emitting module 100 nor the light-transmitting motherboard 3 needs to mount additional electronic components, making the overall product clean and neat.

The transparent light-emitting module 100 of the present technology has a relatively small size, making it easy to manufacture and maintain, while the light-transmitting motherboard 3, having no mounted components, is simple to fabricate and low in cost. The combination of the two reduces quality risks during the production and application processes. In particular, for LED light-emitting dies using built-in driver chips with fixed addresses, it is only necessary to manage the addresses of the light-emitting pixels 2 mounted in the transparent light-emitting module 100, without needing to account for the addresses of light-emitting pixels 2 at different positions on the screen across different projects.

In this application, the transparent light-emitting module 100 and the light-transmitting motherboard 3 are configured separately. The transparent light-emitting module 100 is generally small in size, typically with a length and width within the range of 80-160 mm, which falls within the travel range of precision processing equipment, thereby enabling easier manufacturing of the transparent light-emitting module 100, with higher efficiency and more stable quality. The light-transmitting motherboard 3 can be manufactured in larger sizes; however, due to its relatively simple internal circuit structure and higher integration, stable quality is also easier to ensure. After-sales service is also more convenient.

### Embodiment 2

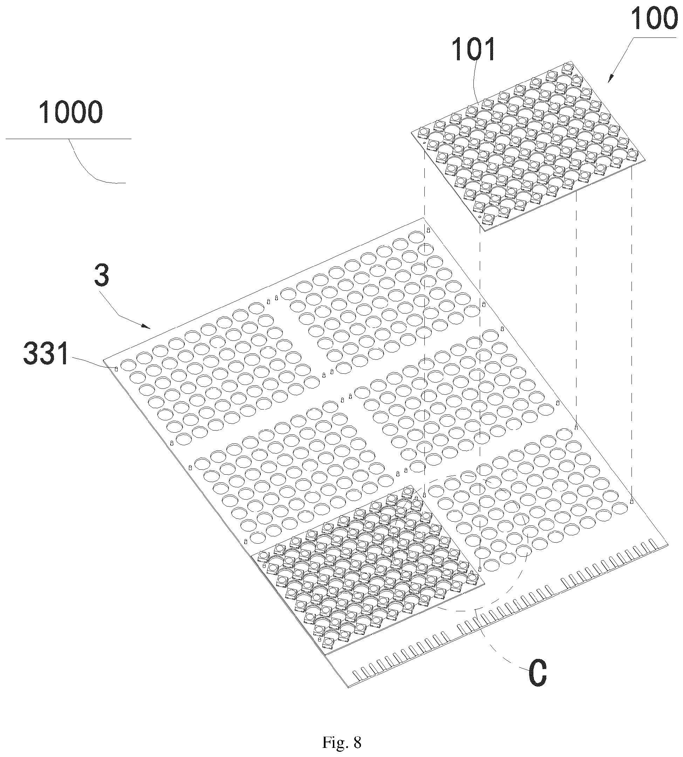

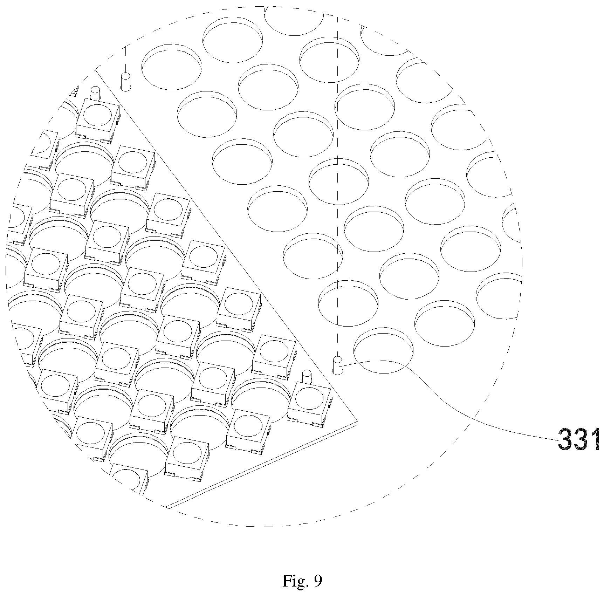

As shown in Figs. 8 and 9, the present embodiment is generally the same as the transparent display screen 1000 disclosed in Embodiment 1 above, with the only differences being in the form and position of the first light-transmitting hole 11 in the transparent light-emitting module 100, and the position and arrangement of the second light-transmitting hole 31 in the light-transmitting motherboard 3.

All the light-transmitting holes on the transparent light-emitting module 100 are full-hole shaped central light-transmitting holes 11a, with no light-transmitting holes arranged around their periphery, thereby forming a peripheral non-light-transmitting area 101. Correspondingly, a plurality of areas corresponding to the transparent light-emitting module 100 are arranged on the light-transmitting motherboard 3. In each area, the light-transmitting holes are also configured as full-hole shaped central light-transmitting holes 11a, the same as those on the transparent light-emitting module 100. No light-transmitting holes are arranged around their periphery either, so that a peripheral non-light-transmitting area is also formed in each area on the light-transmitting motherboard 3 corresponding to the transparent light-emitting module 100.

A plurality of separate electrical connection holes for achieving electrical connection are respectively arranged in the above-mentioned peripheral non-light-transmitting area, to serve respectively as the electrical connection part 13 of the transparent light-emitting module 100 and the module connection part 33 of the light-transmitting motherboard 3. The transparent light-emitting module 100 and the light-transmitting motherboard 3 are then electrically connected via electrical connectors provided in these holes.

In this embodiment, the peripheral edge of the transparent light-emitting module 100 is configured as a non-perforated peripheral non-light-transmitting area, which is advantageous for the flatness and stability of the transparent light-emitting module 100. The peripheral edge provides sufficient routing space, which facilitates processing and also contributes to more reasonable and reliable internal routing.

### Embodiment 3

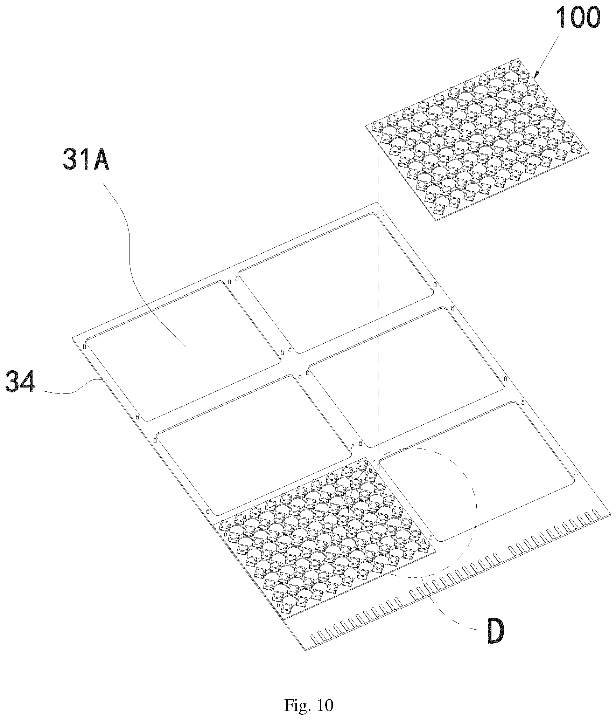

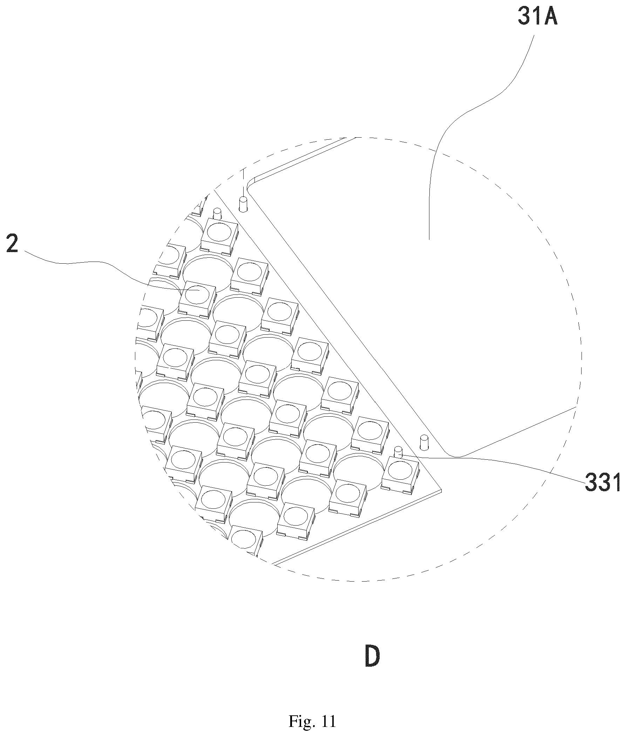

As shown in Figs. 10 and 11, this embodiment is generally the same as the solution in Embodiment 2 and discloses a new transparent display screen 1000. The difference lies in the design of the light-transmitting motherboard 3. The number of transparent light-emitting modules 100 is designed to be N. The light-transmitting motherboard 3 includes a non-light-transmitting frame 34 and N hollow light-transmitting areas 31A formed in the non-light-transmitting frame 34 Each hollow light-transmitting area 31A is correspondingly provided with a transparent light-emitting module 100.

In the peripheral non-light-transmitting area of the transparent light-emitting module 100, several electrical connection holes are separately arranged to serve as the electrical connection part 13 of the transparent light-emitting module 100. Meanwhile, several electrical connection holes are arranged on the non-light-transmitting frame 34 to serve as the module connection part 33 of the light-transmitting motherboard 3. The electrical connection between the transparent light-emitting module 100 and the light-transmitting motherboard 3 is achieved through the electrical connectors.

The light-transmitting motherboard 3 can be in a hollowed-out form, with electrical connection parts distributed at the four corners to achieve the soldering of the light-transmitting motherboard 3 and the transparent light-emitting module 100. On one hand, this provides power and signals to the transparent light-emitting module 100, and on the other hand, it also achieves the mechanical connection of the transparent light-emitting module 100.

### Embodiment 4

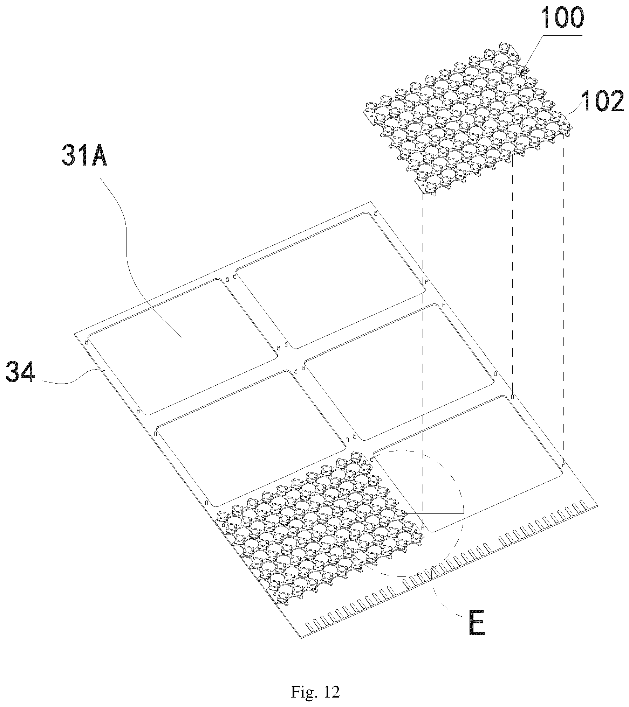

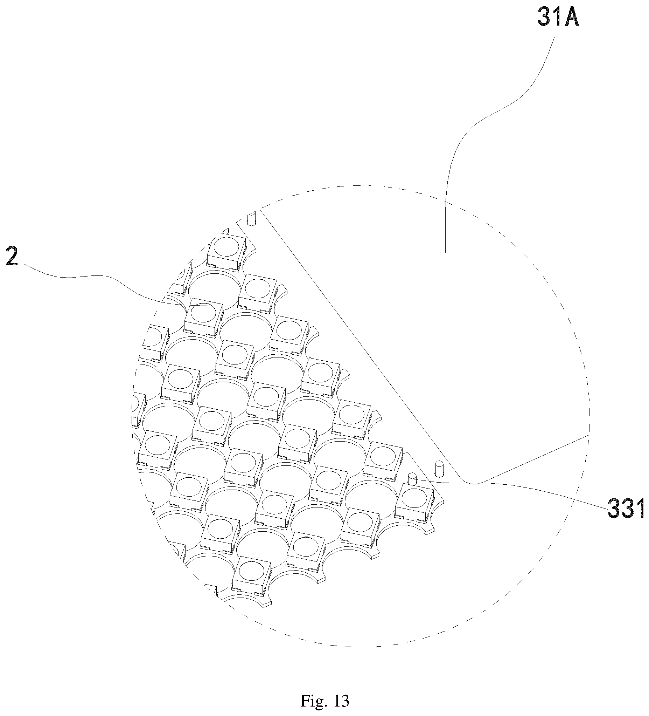

As shown in Figs. 12 and 13, this embodiment discloses a new transparent display screen 1000. Most of the content in this embodiment is the same as that in Embodiment 3, with the difference being in the transparent light-emitting module 100. In this case, the transparent light-emitting module 100 adopts the structure from Embodiment 1. To facilitate the electrical connection, based on Embodiment 1, a peripheral connection area 102 is provided at the corners of the transparent light-emitting module 100. Electrical connection holes are dispersed in the peripheral connection area 102 at the corners as the electrical connection part 13, to be electrically connected to the electrical connection holes on the module connection part 33 dispersed in the non-light-transmitting frame 34 of the light-transmitting motherboard 3. This approach can also achieve a good transparent display effect.

### Embodiment 5

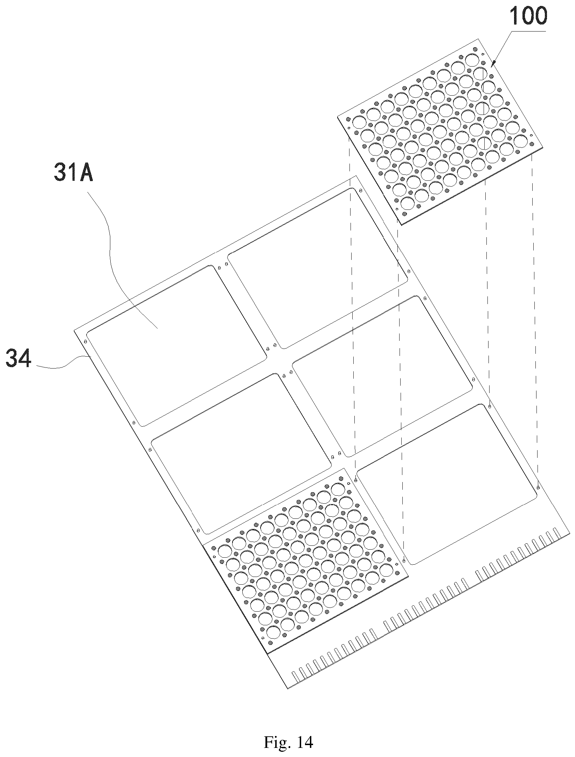

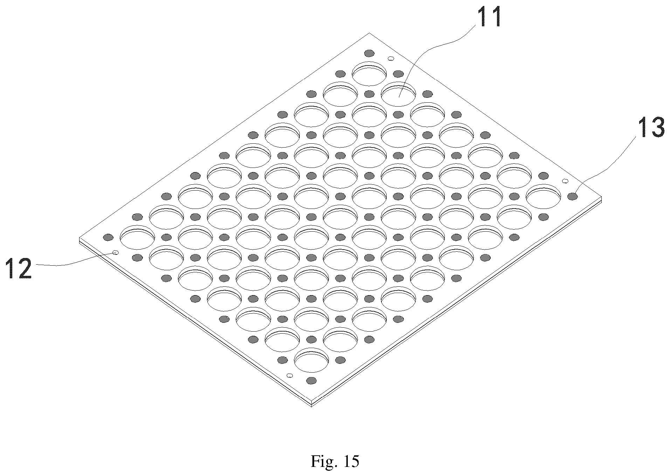

As shown in Figs. 14 and 15, this embodiment discloses a new transparent display screen 1000. Most of the content in this embodiment is the same as in Embodiment 3, with the difference being the adoption of a different transparent light-emitting module 100. This transparent light-emitting module 100 is provided with several pixel recessed holes 12 arranged in an array, in which the light-emitting pixels 2 are mounted. The pixel recessed holes 12 are then filled with a transparent adhesive (not marked in the diagram) to encapsulate the light-emitting pixels 2 inside the pixel recessed holes 12. The light-emitting pixels 2, along with the transparent adhesive, form an LED package encapsulated inside the pixel recessed holes 12. The further encapsulation with transparent adhesive provides additional protection, resulting in a better-sealed transparent light-emitting module 100 with enhanced water and moisture resistance. This also offers further protection for the light-emitting pixels 2 within the pixel recessed holes 12.

### Embodiment 6

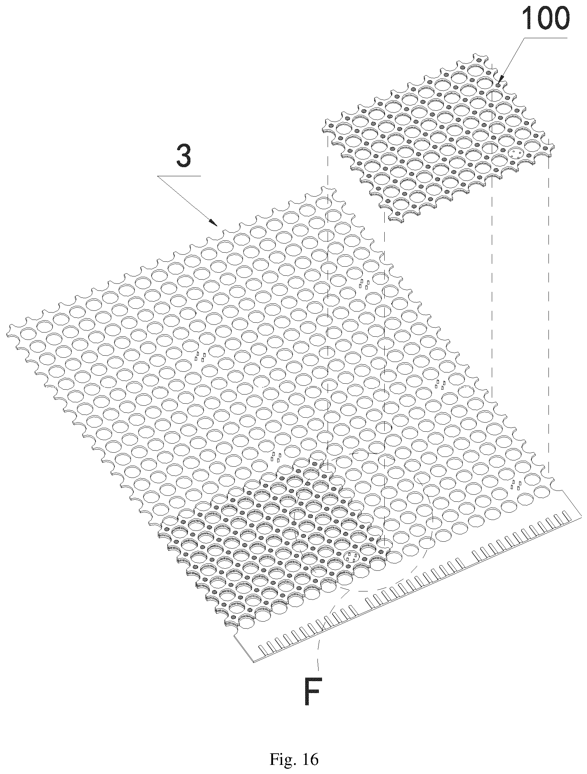

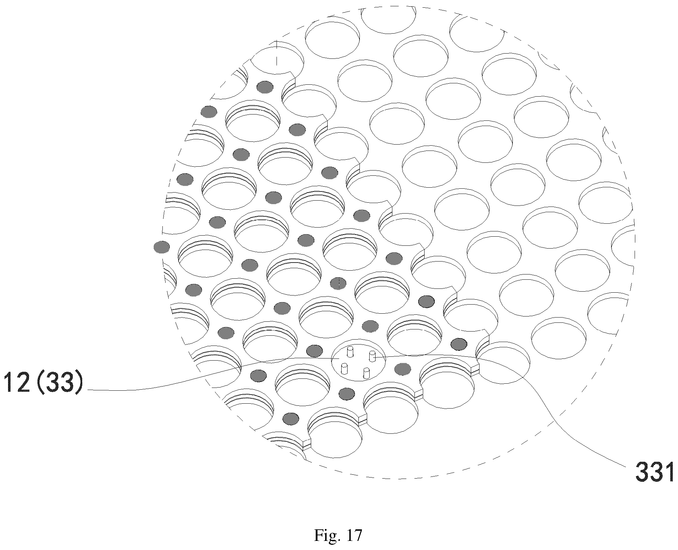

As shown in Figs. 16 and 17, this embodiment discloses a new transparent display screen 1000. The structure of the light-transmitting motherboard 3 in this embodiment is the same as that of the light-transmitting motherboard 3 in Embodiment 1. The transparent light-emitting module 100 adopted in this embodiment is similar to the one in Embodiment 5. This transparent light-emitting module 100 is provided with several pixel recessed holes 12 arranged in an array, in which the light-emitting pixels 2 are installed. The pixel recessed holes 12 are then filled with a transparent adhesive (not marked in the diagram) to encapsulate the light-emitting pixels 2 inside the pixel recessed holes 12. The difference from Embodiment 1 is that the first light-transmitting hole 11 on the transparent light-emitting module 100 includes a central light-transmitting hole 11a of a full-hole shape in the center area, an adjacent-edge light-transmitting hole 11b of a semi-hole shape at the edge positions, and an adjacent-corner light-transmitting hole 11c of a quarter-hole shape at the corner positions. The adjacent-edge light-transmitting holes 11b of two adjacent light-emitting modules can combine to form a full-hole shape, and the adjacent-corner light-transmitting holes 11c of four light-emitting modules can combine to form a full-hole shape.

The above are merely the preferred embodiments of this application, and are not intended to limit the application. Any modification, equivalent substitution and improvement made within the spirit and principle of this application shall be included in the protection scope of this application.

## Claims

1. A transparent display screen, comprising: a light-transmitting motherboard and one or more transparent light-emitting modules mounted on the light-transmitting motherboard; wherein:
the light-transmitting motherboard is provided with a transmission circuit configured to supply power and signals to the transparent light-emitting module; the light-transmitting motherboard and the transparent light-emitting module together present a transparent display effect; and
each transparent light-emitting module is provided with a driver circuit and a plurality of light-emitting pixels arranged in an array, each light-emitting pixel comprises a driver chip and a light-emitting die; each of the light-emitting pixels is connected to the driver circuit, and the driver circuit is connected to the transmission circuit of the light-transmitting motherboard, thereby electrically connecting each transparent light-emitting module to the light-transmitting motherboard to supply power and signals to the light-emitting pixels on the transparent light-emitting module.

2. The transparent display screen of claim 1, wherein:
the transparent light-emitting module is provided with an electrical connection part; and the light-transmitting motherboard is provided with a module connection part, the module connection part on the light-transmitting motherboard is electrically connected to the electrical connection part on the module substrate, thereby electrically connecting the driver circuit on the transparent light-emitting module to the transmission circuit on the light-transmitting motherboard, and supplying power and signals from the light-transmitting motherboard to the transparent light-emitting module.

3. The transparent display screen of claim 2, wherein:
the electrical connection part on the transparent light-emitting module and the module connection part on the light-transmitting motherboard are each correspondingly provided with a plurality of power connection structures and signal connection structures.

4. The transparent display screen of claim 3, wherein:
the power connection structure on the transparent light-emitting module is a first power connection hole, and the signal connection structure is a first signal connection hole; the power connection structure on the light-transmitting motherboard is a second power connection hole, and the signal connection structure is a second signal connection hole; the first power connection hole is connected to the second power connection hole, and the first signal connection hole is connected to the second signal connection hole, via electrical connectors.

5. The transparent display screen of claim 4, wherein:
the power connection structure and the signal connection structure on the transparent light-emitting module are arranged either concentrically or dispersedly at a corner or an edge of the transparent light-emitting module.

6. The transparent display screen of claim 1, wherein:
the transparent light-emitting module and the light-transmitting motherboard are both printed circuit boards, each composed of at least two circuit layers; the light-transmitting motherboard is provided with a light-transmitting area, and the transparent light-emitting module is provided with light-transmitting holes arranged in an array; and
the circuit layers on the light-transmitting motherboard form the transmission circuit, and the transmission circuit is configured to provide power and signals to the module substrate; the circuit layers on the transparent light-emitting module form the driver circuit, and the driver circuit is configured to provide power and signals to each of the light-emitting pixels.

7. The transparent display screen of claim 6, wherein:
the light-transmitting holes on the transparent light-emitting module and the light-transmitting motherboard comprise: central light-transmitting holes of a full-hole shape in the center area, adjacent-edge light-transmitting holes of a semi-hole shape at edge positions, and adjacent-corner light-transmitting holes of a quarter-hole shape at corner positions; the adjacent-edge light-transmitting holes of two adjacent light-emitting modules are able to combine to form a full-hole shape, and the adjacent-corner light-transmitting holes of four adjacent light-emitting modules are able to combine to form a full-hole shape.

8. The transparent display screen of claim 1, wherein:
the number of the transparent light-emitting modules is N, and the light-transmitting motherboard comprises a non-light-transmitting frame and N hollow light-transmitting areas formed in the non-light-transmitting frame, and each hollow light-transmitting area is correspondingly provided with one of the transparent light-emitting modules.

9. The transparent display screen of claim 1, wherein:
the light-transmitting motherboard further is further provided with an external connection port area connected to the power module and the signal module; and the external connection port area is provided with a connection PIN connected to the power module and the signal module.

10. The transparent display screen of claim 1, wherein:
the transparent light-emitting module is adhesively bonded to the light-transmitting motherboard.

11. The transparent display screen of claim 1, wherein:
the light-transmitting motherboard is a transparent glass panel, and the transmission circuit is provided on the transparent glass panel.

12. The transparent display screen of claim 1, wherein:
the transparent light-emitting module comprises a transparent substrate, and the driver circuit is provided on the transparent substrate; and the light-emitting pixels are arranged in an array on the driver circuit of the transparent substrate.
